# EUROPEAN PATENT APPLICATION

(11) **EP 2 613 362 A1**
(43) Date of publication of application: **10.07.2013**
(21) Application number: 11821484.0
(22) Date of filing: 28.07.2011
(51) Int. Cl.: H01L 31/042, B32B 27/32, C08L 23/04

(54) **SOLAR BATTERY COVER FILM FOR AND SOLAR BATTERY MODULE MANUFACTURED USING SAME**

(30) Priority: 27.12.2010 JP 2010290371; 31.08.2010 JP 2010195086
(71) Applicant: Mitsubishi Plastics, Inc., Tokyo 100-8252 (JP)
(72) Inventor: AKAIKE, Osamu, Ushiku-shi Ibaraki 300-1201 (JP); TANIGUCHI, Kouichirou, Nagahama-shi Shiga 526-8660 (JP); OTSUKA, Michiko, Nagahama-shi Shiga 526-8660 (JP); NISHIOKA, Jun, Nagahama-shi Shiga 526-8660 (JP); AYA, Tetsuya, Ushiku-shi Ibaraki 300-1201 (JP); MIYASHITA, Yo, Nagahama-shi Shiga 526-8660 (JP); YAMAMOTO, Ryota, Nagahama-shi Shiga 526-8660 (JP)
(74) Representative: HOFFMANN EITLE
(86) International application number: PCT/JP2011/067229
(87) International publication number: WO 2012/029466

(57) **Abstract**

Provided is a cover film for solar cells, with which solar cell modules are easy to produce, which comprises an encapsulant resin layer excellent in softness, transparency and heat resistance, and a weather-resistant layer excellent in weather resistance, moisture proofness, transparency and heat resistance and having high adhesiveness to the encapsulant resin layer, and is therefore excellent in handleability, and which is effective for reducing the weight of solar cell modules and for enhancing the impact resistance and the durability thereof; and also provided is a solar cell module produced by the use of the cover film for solar cells. Disclosed is production of a cover film for solar cells by laminating a weather-resistant layer or a surface protective layer, and an encapsulant resin layer comprising a resin composition that contains an ethylene-α-olefin random copolymer and an ethylene-α-olefin block copolymer both having specific thermal properties.

## Description

### TECHNICAL FIELD

The present invention relates to a cover film which is used as a protective materials for solar cells and is effective for reducing the weight of solar cells and for enhancing the durability and the output power thereof, and to a lightweight and highly-durable solar cell module produced by the use of the cover film.

### BACKGROUND ART

Recently, with the increase in public awareness of environmental issues such as global warming and others, expectations for solar power generation have been much raised in view of the cleanness thereof and freeness from environmental pollution. A solar cell constitutes the main part of a solar power generation system which directly converts the energy of sunlight into electricity. Regarding the configuration of the solar cell, in general, multiple solar cell elements (simply referred to as cells) are connected in series or in parallel and are packaged for protecting the cells to give individual units. The unit installed in the package is referred to as a solar cell module, and, in general, this is so designed that the solar cell element therein is protected with a surface protective material, or that is, the face of the unit to be exposed to sunlight is covered with a transparent substrate as a top protective material (glass/translucent solar cell sheet; front sheet), and the back thereof is protected with a back sealing sheet (back sheet) as a back protective material, in which the space between the members is sealed up with an encapsulant material (encapsulant resin layer) of a thermoplastic plastic (for example, ethylene-vinyl acetate copolymer). The surface protective material for solar cells is required to be excellent in resistance to UV rays and, in addition, another extremely important factor thereof is that the surface protective material is excellent in moisture proofness in order to prevent the internal conductive wires and electrodes from getting rusted owing to moisture or water penetration thereinto. In particular, using a high-refractivity film such as a white film of polypropylene resin or polyester resin as the back protective material on an uppermost surface of a power generation side could increase the incident light reflectivity to thereby increase the power generation efficiency.
Those solar cell modules are mainly used outdoors, and are therefore required to satisfy various properties in point of the configuration, the material constitution and others thereof. Of those, the encapsulant material is essentially required to have softness and impact resistance for protecting solar cell elements, heat resistance for protecting solar cell modules in heat generation, transparency (total light transmission, etc.) for efficient arrival of sunlight to solar cell elements, durability, dimensional stability, flame retardation, water vapor barrier performance, etc.
Of the necessary properties required for the surface protective material of solar cells, the first is excellent resistance to UV rays, and in addition thereto, another important factor is that the protective material is excellent in moisture proofness in order to prevent the internal conductive wires and electrodes from getting rusted owing to moisture or water penetration thereinto. Consequently, glass has heretofore been widely used as the conventional surface protective material, as described above.
However, though glass plates are excellent in weather resistance and moisture proofness, they have drawbacks in that they are heavy and are readily cracked as not resistant to shock.

Against these, for example, Patent Reference 1 discloses a solar cell module having a film of an acrylic resin or a fluoro polymer as the transparent surface protective film existing on the outermost surface thereof. In particular, a fluoro polymer is excellent in weather resistance and water repellency and can prevent the conversion efficiency of solar cell modules from being reduced owing to yellowing or cloudiness to be caused by resin degradation or owing to light transmittance reduction to be caused by surface pollution.

At present, as an encapsulant material for solar cell elements in solar cell modules, an ethylene-vinyl acetate copolymer (hereinafter this may be abbreviated as EVA) is widely used as the constituent material thereof, from the viewpoint of softness, transparency and the like (for example, see Patent Reference 2). Mainly for imparting heat resistance to EVA, crosslinking is attained with an organic peroxide serving as a crosslinking agent. For this, there is employed a method of previously preparing an EVA sheet mixed with a crosslinking agent (organic peroxide) and a crosslinking promoter and sealing up solar cell elements by the use of the resulting sheet. In the process of preparing the sheet, molding at a low temperature at which the organic peroxide used is not decomposed (in general, 80 to 100°C or so) is needed, and therefore, it is difficult to elevate the speed of extrusion molding; and the sealing process for solar cell elements requires two steps of a step of degassing and temporarily bonding in a laminator taking from a few minutes to a dozen more minutes and another step of finally bonding (crosslinking) in an oven at a high temperature at which the organic peroxide is decomposed (in general, 130 to 150°C or so) taking a few minutes to 60 minutes or so. Consequently, the production of solar cell modules requires a number of processes and much time, therefore providing a problem of increasing the production cost.
Another problem with the encapsulant material for solar cell elements using the EVA sheet is that the solar cell circuit may be corroded by acetic acid to be generated by EVA through hydrolysis in long-term use; and in addition, owing to the crosslinking agent, the crosslinking promoter and even the generated acetic acid, there may occur another problem of delamination at the interface to the solar cell element or at the interface to the front sheet, or even at the interface to the back sheet.

Against these problems, for example, Patent Reference 3 discloses a solar cell encapsulant material comprising a resin composition that contains an amorphous olefin polymer and a crystalline α-olefin polymer, as a solar cell encapsulant material not requiring a crosslinking process, in which concretely used is a resin composition comprising a polymer with propylene as the main component thereof.
Patent Reference 4 discloses a solar cell encapsulant material of a polymer blend or a polymer alloy that comprises at least one polyolefin-based copolymer and at least one crystalline polyolefin, in which concretely used are a polymer blend of a low-melting-point EVA and a high-melting-point EVA (see Example 1), a polymer blend of an ethylene-methacrylic acid copolymer and an ordinary crystalline polyethylene (see Example 2), and a polymer blend of an ethylene-methyl acrylate copolymer and an ordinary crystalline polypropylene (see Example 3).
Further, in a process of producing a solar cell module by separately laminating a front protective material, an encapsulant material, a solar cell element, a back protective material and others, many types of members are needed in lamination, and the process of laminating these at predetermined positions requires many complicated steps, therefore bringing about another problem in that the productivity is poor, the production cost is high and the process is expensive.
Given the situation, Patent Reference 5 discloses a cover film for solar cells, which is produced by laminating an encapsulant layer that indispensably contains a crosslinking agent and contains some other additives, and a front cover film, or concretely a multi-layer laminate film having a weather-resistant layer and a barrier layer.

### CITATION LIST

### PATENT REFERENCES

Patent Reference 1: JP-A 8-139347
Patent Reference 2: JP-A 58-60579
Patent Reference 3: JP-A 2006-210905
Patent Reference 4: JP-A 2001-332750
Patent Reference 5: JP-A 2000-91611

### SUMMARY OF THE INVENTION

### PROBLEMS THAT THE INVENTION IS TO SOLVE

However, of the surface protective film comprising a fluoro resin as in Patent Reference 1, the adhesive force to an encapsulant material is, in general, extremely weak, and when the solar cell module using the film is exposed outside for a long period time, the surface protective film peels off. The surface of the surface protective film and the surface of the encapsulant material are processed to form irregularities thereon, and the two are further processed for corona discharge treatment to thereby increase the adhesive force between them; however, the method is still problematic in that the cost of the process for producing solar cell modules increases.

On the other hand, the resin composition formed of a polymer that comprises propylene as the main component thereof, as in Patent Reference 3, is still insufficient in transparency (total light transmission: 83.2% (see Examples)). In addition, the a polymer that comprises propylene as the main component thereof has another problem in that its brittle temperature is high and its low-temperature properties are poor. The polymer blend used in Patent Reference 4 is not always satisfactory in point of transparency, and is therefore still problematic in the balance among softness, heat resistance and transparency. In other words, even by the findings disclosed in these Patent Reference 3 and Patent Reference 4, any encapsulant material satisfying simultaneously all the quality requirements of softness, heat resistance and transparency has not as yet been obtained.

In case where a combination of such an encapsulant material and a back protective material is used, the incident light to reach the back protective material could be attenuated by the encapsulant material and further, the reflected light could also be attenuated, and therefore the intensity of the light to return to the cell would lower, and as a result, the power generation would greatly lower, therefore having a severe negative influence on the quality of solar cells.
As in the above, in the conventional technique relating to the combination of a back protective material and an encapsulant material for solar cells, any useful means for solving the problem of solar cell performance degradation owing to the reduction in light reflection from a surface layer of the back protective layer has not as yet been proposed.

Further, the filler layer used in Patent Reference 5 contains a crosslinking agent as the indispensable ingredient therein, and therefore could not be given heat resistance when the layer is not processed in a crosslinking process, and consequently, the disclosed technique still has a problem in point of the handleability of the cover film in producing solar cell modules. In addition, the obtained solar cell module is unsatisfactory in point of impact resistance, durability, etc.

Given the situation and in consideration of the above-mentioned problems in the prior art, an object of the present invention is to provide a cover film for solar cells, with which production of solar cell modules is easy, which is produced by laminating an encapsulant resin layer excellent in softness, transparency and heat resistance, and a weather-resistant layer, and is excellent in handleability, and which is effective for reducing the weight of solar cell modules and for enhancing the impact resistance and the durability thereof, and to provide a solar cell module produced by the use of the cover film for solar cells.
Another object of the present invention is to realize long-term durability and high power generation efficiency of solar cell modules by using therein a film layer that comprises a combination of an encapsulant resin layer and a surface protective layer both sufficiently excellent in all of softness, heat resistance and total light transmission and well-balanced in these, especially by securing a high light reflectivity on the surface of the back protective layer in the module.
Still another object of the present invention is to provide a high-efficiency solar cell module that comprises the combination of a solar cell encapsulant resin layer and a back protective layer.

### MEANS FOR SOLVING THE PROBLEMS

As a result of assiduous studies, the present inventors have found that, when a weather-resistant layer or a surface protective layer containing the layer is laminated with an encapsulant resin layer using a resin composition that contains an ethylene-α-olefin random copolymer and an ethylene-α-olefin block copolymer both having specific thermal properties, then the above-mentioned problems can be solved, and have completed the present invention.

Specifically, the present invention relates to a cover film for solar cells, which has a weather-resistant layer or a surface protective layer, especially a back protective layer containing it, and an encapsulant resin layer comprising a resin composition (C) that contains an ethylene-α-olefin random copolymer (A) satisfying the following requirement (a) and an ethylene-α-olefin block copolymer (B) satisfying the following requirement (b):
(a) The heat of crystal fusion of the copolymer, as measured at a heating rate of 10°C/min in differential scanning calorimetry, is from 0 to 70 J/g;
(b) As measured at a heating rate of 10°C/min in differential scanning calorimetry, the crystal melting peak temperature of the copolymer is 100°C or higher, and the heat of crystal fusion thereof is from 5 to 70 J/g.

The present invention also relates to a solar cell module produced by the use of the cover film for solar cells of the present invention.

### ADVANTAGE OF THE INVENTION

The cover film for solar cells of the present invention comprises an encapsulant resin layer excellent in softness, transparency and heat resistance and a weather-resistant layer as laminated therewith, and is excellent in handleability. The cover film can reduce the weight of solar cell modules and can enhance the impact resistance and the durability thereof.
According to the present invention, in the laminate having a solar cell encapsulant layer and a surface protective layer, the two layers each are made to have a specific configuration, whereby the softness, the heat resistance and the total light transmission of the film layer can be well-balanced; and consequently, high reflectivity can be secured on the surface layer of the back protective layer to thereby realize long-term weather resistance and high power generation efficiency of solar cells. The present invention therefore provides a laminate for solar cell protection effective for reducing the weight of solar cells and for enhancing the durability thereof.

### BRIEF DESCRIPTION OF THE DRAWING

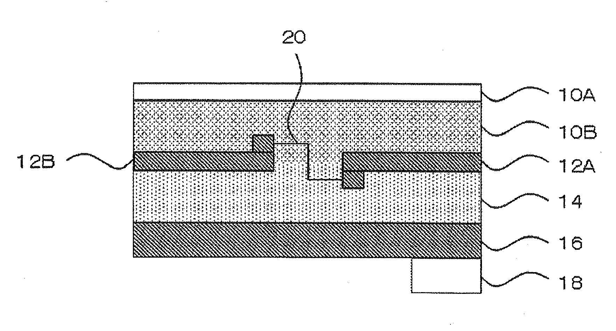

[Fig. 1] This is a schematic cross-sectional view showing one example of an embodiment of the solar cell module of the present invention.

### MODE FOR CARRYING OUT THE INVENTION

The cover film for solar cells of the present invention, and the solar cell module produced by the use of the cover film are described below.

### <Weather-Resistant Layer>

Not specifically defined, the weather-resistant layer in the present invention may be any one that has properties such as weather resistance and the like generally required for solar cell modules; however, in the present invention, preferred is a layer excellent in flexibility, weather resistance, moisture proofness, transparency, heat resistance, and adhesiveness to the encapsulant resin layer mentioned below. As one preferred embodiment thereof, the layer alone may be laminated with the encapsulant resin layer mentioned below; however, the layer may constitute the surface protective layer mentioned below.
From these viewpoints, preferably, the weather-resistant layer is a layer of a resin composition that contains at least one resin selected from acrylic resin, polycarbonate resin, polyethylene terephthalate resin and polyethylene naphthalate resin, and a UV absorbent, or a layer comprising a fluoro resin as the main component thereof. Of those, more preferred is a layer comprising a fluoro resin as the main component thereof for the reason that the layer is excellent in weather resistance.

In the present specification, the "main component " is stated to the effect that the composition may contain any other component within a rage not detracting from the effect and the advantage of the resin that constitute the individual layers of the solar cell cover film of the present invention. Further, though the term thereof is not to restrict any concrete content, the main component is an component that accounts for generally 50 parts by mass or more relative to 100 parts by mass of all the constituent component of the resin composition, preferably 65 parts by mass or more, more preferably 80 parts by mass or more, and is 100 parts by mass or less.

As the fluoro resin, preferably employed here are polytetrafluoroethylene (PTFE), 4-fluoroethylene-perchloroalkoxy copolymer (PFA), 4-fluoroethylene-6-fluoropropylene copolymer (FEP), 2-ethylene-tetrafluoroethylene copolymer (ETFE), polychloro-trifluoroethylene (PCTFE), polyvinylidene fluoride (PVDF), polyvinyl fluoride (PVF), etc.
Of those, preferred are ETFE and FEP as excellent in weather resistance, moisture proofness and transparency and additionally having fouling resistance and flame retardance. Preferably, ETFE for use herein has a melting point of from 150 to 270°C from the viewpoint of the heat resistance thereof.

As the acrylic resin to constitute the resin composition, preferably used here is a methacrylic resin from the viewpoint of the weather resistance and the transparency thereof. The methacrylic resin is preferably one comprising a methyl methacrylate unit as the main component thereof, concretely a methyl methacrylate resin that has a methyl methacrylate unit generally in an amount of 50% by mass or more, preferably 70% by mass or more. The methacrylic resin may be a methyl methacrylate homopolymer comprising 100% by mass of a methyl methacrylate unit, or may also be a copolymer of methyl methacrylate with any other monomer.

Examples of the monomer copolymerizable with methyl methacrylate include methacrylates except methyl methacrylate, such as ethyl methacrylate, butyl methacrylate, cyclohexyl methacrylate, phenyl methacrylate, benzyl methacrylate, 2-ethylhexyl methacrylate, 2-hydroxyethyl methacrylate; and acrylates such as methyl acrylate, ethyl acrylate, butyl acrylate, cyclohexyl acrylate, phenyl acrylate, benzyl acrylate, 2-ethylhexyl acrylate, 2-hydroxyethyl acrylate. There are additionally mentioned styrene and substituted styrenes, for example, halogenostyrenes such as chlorostyrene, bromostyrene, and alkylstyrenes such as vinyltoluene, α-methylstyrene, etc. Further mentioned are unsaturated acids such as methacrylic acid, acrylic acid; and acrylonitrile, methacrylonitrile, maleic anhydride, phenylmaleimido, cyclohexylmaleimide, etc. One alone or two or more of these other monomers copolymerizable with methyl methacrylate may be used here either singly or as combined.

The above-mentioned UV absorbent to be added to at least one resin selected from acrylic resin, polycarbonate resin, polyethylene terephthalate resin and polyethylene naphthalate resin include various types of UV absorbents such as benzophenone-type, benzotriazole-type, triazine-type and salicylate-type UV absorbents, etc., for which various types of commercial products are usable here. The benzophenone-type UV absorbents include, for example, 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, 2,2',4,4'-tetrahydroxybenzophenone, etc.

The benzotriazole-type UV absorbents include hydroxyphenyl-substituted benzotriazole compounds, for example, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-amylphenyl)benzotriazole, 2-(2-hydroxy-3,5-di-t-butylphenyl)benzotriazole, etc. The triazine-type UV absorbents include 2-[4,6-bis(2,4-dimethylphenyl)-1,3,5-triazin-2-yl]-5-(octyloxy)phenol, 2-(4,6-diphenyl-1,3,5-triazin-2-yl)-5-(hexyloxy)phenol, etc. The salicylate-type UV absorbents include phenyl salicylate, p-octylphenyl salicylate, etc.
The amount of the UV absorbent to be added is preferably from 0.05 to 10 parts by mass relative to 100 parts by mass of the resin to constitute the weather-resistant layer.

To the weather-resistant layer to constitute the cover film of the invention, any other weather-resistant stabilizer for imparting weather resistance than the above-mentioned UV absorbents may be added. As the weather-resistant stabilizer, preferably used here are hindered amine-type light stabilizers. The hindered amine-type light stabilizer does not absorb UV rays, different from UV absorbents, but when combined with a UV-absorbent, it exhibits a noticeable synergistic effect.

The hindered amine-type light stabilizer includes dimethyl succinate-1-(2-hydroxyethyl)-4-hydroxy-2,2,6,6-tetramethylpiperidine polycondensate, poly[{6-(1,1,3,3-tetramethylbutyl)amino-1,3,5-triazine-2,4-diyl}{(2,2,6,6-tetramethyl-4-piperidyl)imino}hexamethylene{{2,2,6,6-tetramethyl-4-piperidylliminoll, N,N'-bis(3-aminopropyl)ethylenediamine-2,4-bis[N-butyl-N-(1,2,2,6,6-pentamethyl-4-piperidyl)amino]-6-chloro-1,3,5-triazine condensate, bis(2,2,6,6-tetramethyl-4-piperidyl) sebacate, bis(1,2,2,6,6-pentamethyl-4-piperidyl) 2-(3,5-di-tert-4-hydroxybenzyl)-2-n-butylmalonate, etc. The amount of the hindered amine-type light stabilizer to be added is, in general, preferably from 0.05 to 10 parts by mass relative to 100 parts by mass of the resin to constitute the weather-resistant layer.

The thickness of the weather-resistant layer in the present invention is not specifically defined. However, from the viewpoint of cell protection, the thickness is preferably within a range of from 5 to 200 µm, more preferably from 20 to 200 µm, even more preferably from 30 to 12 µm, still more preferably from 30 to 80 µm.

The weather resistance of the weather-resistant layer is preferably as follows: In a weather resistance test with a sunshine weather meter according to JIS K7350, preferably, the mechanical properties and the total light transmission of the layer lower little. More preferably, after 5000 hours in the test, the mechanical properties and the total light transmission do not lower; and even more preferably, after 10000 hours, the mechanical properties and the total light transmission do not lower.

Regarding the moisture proofness of the weather-resistant layer, preferably, the water vapor transmission rate through the layer, as measured according to JIS K7129, is within a range of from 0.1 to 50 g/m²·day, more preferably from 0.5 to 10 g/m²·day.

The total light transmission of the weather-resistant layer, as measured according to JIS K7105, is, in general, preferably 85% or higher inconsideration of the type of the solar cells to which the cover film is applied, the power generation efficiency thereof, and the handleability of the layer in laminating with various members, but is more preferably 90% or higher.

The heat resistance of the weather-resistant layer may be evaluated by analyzing it in the same manner as that for the encapsulant resin layer to be mentioned below, and preferably, the condition of the layer after a predetermined period of time is good.

### <Surface Protective Layer>

The surface protective layer in the present invention is a thermoplastic resin sheet for solar cells or a thermoplastic resin sheet laminate for solar cells, and is used for protecting solar cell modules from stain, water vapor, etc.
The surface protective layer is preferably a polyolefin-based resin layer, and for satisfying various requirements of preventing water vapor penetration into the layer or preventing the UV degradation of the layer, the surface protective layer is more preferably produced by laminating a polyolefin-based resin layer, a moisture-proof layer, a weather-resistant layers and others via an adhesive agent. In particular, in case where the surface protective layer is a back surface protective layer, it is desirable that a white resin layer having a light reflectivity of 80% or higher is used as the polyolefin-based resin layer, for increasing the power generation efficiency of the solar cell module by returning the light having reached the back surface protective layer again to the solar cell element.

The surface protective layer may be produced by dry-laminating the films to constitute the above-mentioned individual layers, using a polyurethane-based adhesive at temperature of from 0 to 80°C followed by drying the adhesive at a temperature of from 100 to 140°C. From the viewpoint that the adhesive is made to reach a sufficiently saturated crosslinking degree, preferably, the obtained laminate is cured at a temperature of from 30 to 80°C for 1 to 7 days. Through the lamination process as above, the obtained laminate is still excellent in softness and moisture proofness with no degradation in moisture proofness and interlayer strength thereof.

The thickness of the surface protective layer is not specifically defined. In general, the layer is used in the form of a sheet having a thickness of from 30 to 100 µm or so, preferably from 40 to 80 µm or so, more preferably from 40 to 60 µm or so.

### (Polyolefin-based Resin Layer)

The polyolefin-based resin layer is not specifically defined. For example, as the main component of the layer, usable is a resin of polyethylene terephthalate, polycarbonate, polymethyl methacrylate, polyacrylate, polyethylene naphthalate, acrylic, polypropylene, polyethylene or the like polyolefins, as these are inexpensive. In view of the flexibility and wet durability thereof, preferred is an unstretched polypropylene film layer comprising an isotactic polypropylene resin as the main component thereof. In case where the layer is used as a back protective layer, the layer can reflect the light having entered the back protective layer to return it to the solar cell element, thereby enhancing the power generation efficiency of the solar cell; and preferably, the layer is laminated as the outermost surface of the back protective layer. Preferably, the polyolefin-based resin layer is a white resin layer produced by kneading a white pigment in a resin.

In particular, when the layer is laminated with the encapsulant resin layer, preferably used is polyolefin since the encapsulant resin layer comprises polyolefin as the main component thereof and therefore light diffraction at the encapsulant resin layer-back protective layer interface can be prevented and the adhesiveness of the layer to the encapsulant resin layer can be enhanced.
As the white pigment, usable are titanium oxide and zinc oxide. Such a white pigment is added to the above-mentioned resin to provide a white resin layer having a light reflectivity of 80% or higher. Preferably, the thickness of the polyolefin-based resin layer is from 40 to 200 µm or so, and from the viewpoint of securing partial discharge resistance, the thickness is more preferably from 80 to 180 µm.
The light reflectivity of the polyolefin-based resin layer is preferably 80% or higher, as measured according to the light reflectivity measuring method to be mentioned below, more preferably 85% or higher.

### (Moisture-proof Layer)

The moisture-proof layer in the present invention is used for preventing the internal conductive wires and electrodes from getting rusted owing to moisture or water penetration thereinto, and not specifically defined, the layer may be any film excellent in moisture proofness but preferably having high transparency. Preferred for use herein is a transparent moisture-proof layer having at least one inorganic oxide coating film on at least one side of a substrate film.

As the substrate film, preferred is a thermoplastic polymer film, and not specifically defined, its material may be any resin usable for ordinary wrapping materials. Concretely, there are mentioned polyolefins of homopolymers or copolymers of ethylene, propylene, butene or the like; amorphous polyolefins such as cyclic polyolefins; polyesters such as polyethylene terephthalate (PET), polyethylene naphthalate (PEN), etc.; polyamides such as nylon 6, nylon 66, nylon 12, copolymer nylon, etc.; ethylene/vinyl acetate copolymer partial hydrolyzates (EVOH), polyimide, polyether imide, polysulfone, polyether sulfone, polyether ether ketone, polycarbonate, polyvinyl butyral, polyarylate, fluoro resin, acrylate resin, biodegradable resin, etc. Of those, preferred are polyester, polyamide and polyolefin from the viewpoint of the film properties and the cost thereof. Above all, from the viewpoint of the film properties thereof, especially preferred are polyethylene terephthalate (PET) and polyethylene naphthalate (PEN).

The substrate film may contain any known additives, for example, antistatic agent, light-blocking agent, UV absorbent, plasticizer, lubricant, filler, colorant, stabilizer, release agent, crosslinking agent, antiblocking agent, antioxidant, etc.

The thermoplastic polymer film serving as the substrate film may be produced by the use of the above-mentioned materials. When used as the substrate, the film may be unstretched or stretched. If desired, the film may be laminated with any other plastic substrate.

The substrate film may be produced according to any conventional known method. For example, a raw resin is melted in an extruder, then extruded through a circular die or a T-die, and rapidly cooled to produce a substantially amorphous unstretched film with no orientation. Using a multilayer die, a single-layer film formed of one type of resin, or a multilayer film formed of one type of resin, or a multilayer film formed of multiple types of resins may be produced.

The unstretched film may be stretched in the film flow direction (machine direction) or in the direction vertical to the film flow direction (lateral direction), according to a known method of monoaxial stretching, tenter-type successive biaxial stretching, tenter-type simultaneous biaxial stretching, tubular-type simultaneous biaxial stretching or the like, thereby producing a film stretched in at least one axial direction. The draw ratio in stretching may be preset in any desired manner, but is preferably so preset that the thermal shrinkage of the film at 150°C could be from 0.01 to 55%, more preferably from 0.01 to 2%. In particular, from the viewpoint of the film properties thereof, preferred is a biaxially-stretched polyethylene naphthalate film or a co-extruded biaxially-stretched film of polyethylene terephthalate and/or polyethylene naphthalate with any other plastic.

Preferably, an anchor-coating agent is applied to the substrate film for enhancing the adhesiveness thereof to an inorganic thin film. As the anchor-coating agent, usable here are one or more of solvent-base or water-base polyester resins, isocyanate resins, urethane resins, acrylic resins, vinyl-modified resins, vinyl alcohol resins, vinyl butyral resins, ethylene vinyl alcohol resins, nitrocellulose resins, oxazoline group-containing resins, carbodiimide group-containing resins, methylene group-containing resins, epoxy group-containing resins, modified styrene resins, modified silicone resins, alkyl titanates and the like either singly or as combined. In addition, the film may further contain a silane-based coupling agent, a titanium-based coupling agent, a light-blocking agent, a UV absorbent, a stabilizer, a release agent, a blocking inhibitor, an antioxidant, etc., and a copolymer prepared by copolymerizing any of these with the above-mentioned resin may also be used.

For forming the anchor-coating layer, any known coating method is suitably employed here. For example, any coating method with a reverse roll coater, a gravure coater, a rod coater, an air knife coater, a spray or a brush is usable here. A vapor-deposited film may be immersed in a resin fluid. After coated, the film may be dried in a heat-drying mode of hot air drying, hot roll drying or the like at a temperature of from 80 to 200°C or so or in a mode of IR drying or well-known drying, thereby to vaporize the solvent. In addition, for enhancing water resistance and durability thereof, the layer may be crosslinked through irradiation to electron beams. For forming the anchor-coating layer, employable here is an in-line method of forming the layer in the production line for the substrate film, or an off-line method of forming the layer after the substrate film production.

As the moisture-proof layer, there is known a case where a metal coating film of aluminium or the like is formed on the substrate film. However, a metal such as aluminium or the like, when applied to solar cells, involves a risk of current leakage, and therefore, a coating film of an inorganic oxide such as silica, alumina or the like is preferably used.

As the method for forming the inorganic oxide coating film, herein employable is any method of a vapor deposition method, a coating method or the like. Preferred is a vapor deposition method as capable of forming a uniform thin film with high gas barrier performance. The vapor deposition method includes physical vapor deposition method (PVD), a chemical vapor deposition method (CVD), etc. The physical vapor deposition method includes vacuum evaporating, ion plating, sputtering, etc. The chemical vapor deposition includes plasma CVD using plasma, catalytic chemical vapor deposition (Cat-CVD) of catalytically thermal-cracking a material gas by the use of a thermal catalyst, etc.

The inorganic substance to constitute the inorganic oxide coating film includes silicon, aluminium, magnesium, zinc, tin, nickel, titanium, hydrogenated carbon or the like, as well as their oxides, carbides, nitrides and their mixtures. Preferred are silicon oxide, aluminium oxide, and diamond-like carbon mainly comprising hydrogenated carbon. In particular, preferred are silicon oxide, silicon nitride, silicon oxynitride and aluminium oxide as capable of stably maintaining high gas barrier performance.

The thickness of the coating film is preferably from 40 to 1000 nm from the viewpoint of expressing stable moisture proofness, more preferably from 40 to 800 nm, even more preferably from 50 to 600 nm. The thickness of the substrate film is generally from 5 to 100 µm or so, and is preferably from 8 to 50 µm from the viewpoint of the productivity and the handleability of the film, more preferably from 12 to 25 µm. Accordingly, the thickness of the moisture-proof layer is from 6 to 100 µm or so, from the viewpoint of the productivity and the handleability of the film, the thickness is preferably from 9 to 50 µm, more preferably from 12 to 25 µm.

### (Weather-Resistant Layer)

The weather-resistant layer to constitute the surface protective layer in the present invention is used on the surface (outside-exposure side) of the surface protective layer, for which the above-mentioned weather-resistant layer may be used.

### <Encapsulant Resin Layer>

The encapsulant resin layer in the present invention is a layer excellent in softness, transparency and heat resistance and is favorable for encapsulant solar cell elements, and in a solar cell, the layer is laminated with the above-mentioned weather-resistant layer or with the surface protective layer containing the weather-resistant layer, and is used for encapsulant solar cell elements. As the encapsulant resin layer, concretely used is a film of an ethylene-α-olefin copolymer as highly transparent, rich in flexibility and excellent in heat resistance and hydrolysis resistance, and further, it is necessary to use a resin composition containing an ethylene-α-olefin random copolymer having specific thermal properties and an ethylene-α-olefin block copolymer having specific thermal properties, from the viewpoint of expressing high-level light transmittance, heat resistance and softness. Concretely, it is necessary that the encapsulant resin layer comprises a resin composition (C) that contains an ethylene-α-olefin random copolymer (A) satisfying the following requirement (a) and an ethylene-α-olefin block copolymer (B) satisfying the following requirement (b):
(a) The heat of crystal fusion of the copolymer, as measured at a heating rate of 10°C/min in differential scanning calorimetry, is from 0 to 70 J/g;
(b) As measured at a heating rate of 10°C/min in differential scanning calorimetry, the crystal melting peak temperature of the copolymer is 100°C or higher, and the heat of crystal fusion thereof is from 5 to 70 J/g.

### [Ethylene-α-Olefin Random Copolymer (A)]

The ethylene-α-olefin random copolymer (A) for use in the present invention is not specifically defined so far as it satisfies the above-mentioned requirement (a). In general, preferably used is a random copolymer of ethylene and an α-olefin having from 3 to 20 carbon atoms. In this, the α-olefin to copolymerize with ethylene includes propylene, 1-butene, 1-pentene, 1-hexene, 1-heptene, 1-octene, 1-nonene, 1-decene, 3-methyl-butene-1, 4-methyl-pentene-1, etc. In the present invention, propylene, 1-butene, 1-hexene and 1-octene are preferably used as the α-olefin to copolymerize with ethylene, from the viewpoint of the industrial availability, various special properties and the economic potential thereof. One alone or two or more different types of α-olefins to copolymerize with ethylene may be used here either singly or as combined.

The content of the α-olefin to copolymerize with ethylene is not specifically defined so far as it satisfies the above-mentioned requirement (a). In general, the content is 2 mol% or more relative to the total monomer units in the ethylene-α-olefin random copolymer (A), and preferably 40 mol% or less, more preferably from 3 to 30 mol%, even more preferably from 5 to 25 mol%. Falling within the range, the comonomer may reduce the crystallinity of the copolymer and may therefore enhance the transparency thereof; and another advantage thereof is that the raw material pellets are prevented from blocking together. The type and the content of the α-olefin to copolymerize with ethylene may be determined through qualitative and quantitative analysis according to a known method, for example, using a nuclear magnetic resonance (NMR) apparatus or any other analyzer.

The ethylene-α-olefin random copolymer (A) may contain any other monomer unit derived from other monomers than α-olefins, so far as it satisfies the above-mentioned requirement (a). The additional monomer includes, for example, cyclic olefins, vinyl-aromatic compounds (styrene, etc.), polyene compounds, etc. The content of the additional monomer unit is preferably 20 mol% or less based on all the monomer units, 100 mol% in the ethylene-α-olefin random copolymer (A), more preferably 15 mol% or less. The configuration, the branched structure, the branching degree distribution and the molecular weight distribution of the ethylene-α-olefin random copolymer (A) are not specifically defined, so far as the copolymer satisfies the above-mentioned requirement (a). For example, a copolymer having long-chain branches could generally have good mechanical properties and have advantages in that its melt tension in molding into sheets is high and the calendering moldability thereof is good. A copolymer having a narrow molecular weight distribution, as produced through polymerization with a single-site catalyst, contains few low-molecular-weight components, and another advantage thereof is that the raw material pellets hardly block together.

Not specifically defined, the melt flow rate (MFR) of the ethylene-α-olefin random copolymer (A) for use in the present invention is generally from 0.5 to 100 g/10 min or so as MFR thereof (JIS K7210, temperature: 190°C, load: 21.18 N), more preferably from 2 to 50 g/10 min, even more preferably from 3 to 30 g/10 min. In this, MFR may be selected in consideration of the moldability and the workability in molding into sheets, the adhesiveness and the spreadability in encapsulant solar cell elements (simply referred to as cells), etc. For example, when sheets are produced through calender-molding, MFR of the copolymer to be used is preferably a relatively low value, concretely from 0.5 to 5 g/10 min or so in view of the handleability in peeling the sheet from molding rolls; but when sheets are produced through extrusion using a T-die, MFR of the copolymer is preferably from 2 to 50 g/10 min, more preferably from 3 to 30 g/10 min from the viewpoint of reducing the extrusion load and increasing the extrusion output. Further, from the viewpoint of the adhesiveness and the spreadability in encapsulant solar cell elements (simply referred to as cells), MFR of the copolymer to be used is preferably from 2 to 50 g/10 min, more preferably from 3 to 30 g/min.

The production method for the ethylene-α-olefin random copolymer (A) for use in the present invention is not specifically defined, for which is employable any known polymerization method using a known olefin polymerization catalyst. For example, there are mentioned a slurry polymerization method, a solution polymerization method, a bulk polymerization method, a vapor-phase polymerization method or the like using a multi-site catalyst such as typically a Ziegler-Natta catalyst, or a single-site catalyst such as typically a metallocene catalyst or a post-metallocene catalyst, and a bulk polymerization method using a radical initiator, etc. In the present invention, since the ethylene-α-olefin random copolymer (A) is a relatively soft resin and from the viewpoint of attaining easy granulation (pelletization) after polymerization and also from the viewpoint of preventing the raw material pellets from blocking together, preferred is a polymerization method using a single-site catalyst, in which a raw material can be polymerized to give a polymer having few low-molecular-weight components and having a narrow molecular weight distribution.

The heat of crystal fusion of the ethylene-α-olefin random copolymer (A) for use in the present invention, as measured at a heating rate of 10°C/min in differential scanning calorimetry (the requirement (a)), must fall from 0 to 70 J/g, and is preferably from 5 to 70 J/g, even more preferably from 10 to 65 J/g. Falling within the range, the copolymer is preferred as capable of securing the softness and the transparency (total light transmission) of the solar cell encapsulant material in the present invention. When the heat of crystal fusion is 5 J/g or higher, it is favorable since the raw material pellets hardly block together. Some reference data of heat of crystal fusion are shown here. Ordinary high-density polyethylene (HDPE) has from 170 to 220 J/g or so, and low-density polyethylene resin (LDPE) and linear low-density polyethylene (LLDPE) has from 100 to 160 J/g or so.
The heat of crystal fusion may be measured at a heating rate of 10°C/min, using a differential scanning calorimeter and according to JIS K7122.

Not specifically defined, the crystal melting peak temperature of the ethylene-α-olefin random copolymer (A) for use in the present invention is generally lower than 100°C, and is often from 30 to 90°C. Some reference data of the crystal melting peak temperature are shown here. Ordinary high-density polyethylene (HDPE) has from 130 to 145°C or so, and low-density polyethylene resin (LDPE) and linear low-density polyethylene (LLDPE) has from 100 to 125°C or so. Specifically, by itself, the ethylene-α-olefin random copolymer (A) for use in the present invention could hardly attain, as measured at a heating rate of 10°C/min in differential scanning calorimetry, a crystal melting peak temperature of 100°C or higher and a heat of crystal fusion of from 5 to 70 J/g.
The Crystal melting peak temperature can be measured at a heating rate of 10°C/min, using a differential scanning calorimeter and according to JIS K7121.

Specific examples of the ethylene-α-olefin random copolymer (A) for use in the present invention include Dow Chemical's trade names "Engage" and "Affinity", Mitsui Chemical's trade names "TAFMER A" and TAFMER P", Japan Polyethylene's trade name "Karnel", etc.

### [Ethylene-α-Olefin Block Copolymer (B)]

The ethylene-α-olefin block copolymer (B) for use in the present invention is not specifically defined so far as it satisfies the above-mentioned requirement (b). In general, preferably used is a block copolymer of ethylene and an α-olefin having from 3 to 20 carbon atoms. In this, the α-olefin to copolymerize with ethylene includes propylene, 1-butene, 1-pentene, 1-hexene, 1-heptene, 1-octene, 1-nonene, 1-decene, 3-methyl-butene-1, 4-methyl-pentene-1, etc. In the present invention, propylene, 1-butene, 1-hexene and 1-octene are preferably used as the α-olefin to copolymerize with ethylene, from the viewpoint of the industrial availability, various special properties and the economic potential thereof. One alone or two or more different types of α-olefins to copolymerize with ethylene may be used here either singly or as combined.

The ethylene-α-olefin block copolymer (B) may contain any other monomer unit derived from other monomers than α-olefins, so far as it satisfies the above-mentioned requirement (b). The additional monomer includes, for example, cyclic olefins, vinyl-aromatic compounds (styrene, etc.), polyene compounds, etc. The content of the monomer unit is 20 mol% or less relative to the total monomer units, 100 mol% in the ethylene-α-olefin block copolymer (B), preferably 15 mol% or less.

Not specifically defined, the block structure of the ethylene/α-olefin block copolymer (B) for use in the present invention may be any one satisfying the above-mentioned requirement (b), but preferred is a multi-block structure comprising two or more, preferably three or more segments or blocks differing from each other in point of the comonomer content, the crystallinity, the density, the crystal melting peak temperature (melting point Tm) or the glass transition temperature (Tg) thereof, from the viewpoint of attaining well-balanced softness, heat resistance, transparency and others. Concretely, there are mentioned a completely symmetric block structure, an asymmetric block structure, a tapered block structure (in which the proportion of the block structures gradually increases in the main chain), etc. Regarding the configuration of the copolymer having the multi-block structure and the production method for the copolymer, those described in detail in WO2005/090425, WO2005/090426, WO2005/090427 and others may be hereby incorporated by reference.

In the present invention, the ethylene/α-olefin block copolymer having a multi-block structure is described in detail hereinunder.
The ethylene-α-olefin block copolymer having a multi-block structure is favorably used in the present invention, and preferred is an ethylene-octene multi-block copolymer in which 1-octene is the comonomer, α-olefin. The block copolymer is preferably a multi-block copolymer that comprises two or more, nearly amorphous soft segments in which the proportion of the copolymerized octene component is large (about 15 to 20 mol%) relative to ethylene, and at least two, high-crystalline hard segments in which the proportion of the copolymerized octene component is small (less than about 2 mol%) relative to ethylene and which have a crystal melting peak temperature of from 110 to 145°C. By suitably controlling the chain length and the proportion of these soft segments and hard segments therein, the block copolymer can be made to satisfy both softness and heat resistance.
Specific examples of the multi-block structure-having copolymer include Dow Chemical's trade name "Infuse".

Not specifically defined, the melt flow rate (MFR) of the ethylene-α-olefin block copolymer (B) for use in the present invention is generally from 0.5 to 100 g/10 min or so as MFR thereof (JIS K7210, temperature: 190°C, load: 21.18 N), more preferably from 1 to 50 g/10 min, even more preferably from 1 to 30 g/10 min, still more preferably from 1 to 10 g/10 min.

In this, MFR may be selected in consideration of the moldability and the workability in molding into sheets, the adhesiveness and the spreadability in encapsulant solar cell elements (simply referred to as cells), etc. Concretely, when sheets are produced through calender-molding, MFR of the copolymer to be used is preferably a relatively low value, concretely from 0.5 to 5 g/10 min or so in view of the handleability in peeling the sheet from molding rolls; but when sheets are produced through extrusion using a T-die, MFR of the copolymer is preferably from 1 to 30 g/10 min from the viewpoint of reducing the extrusion load and increasing the extrusion output. Further, from the viewpoint of the adhesiveness and the spreadability in encapsulant solar cell elements (simply referred to as cells), MFR of the copolymer to be used is preferably from 3 to 50 g/min.

The ethylene-α-olefin block copolymer (B) for use in the present invention must satisfy the requirement (b) that, as measured at a heating rate of 10°C/min in differential scanning calorimetry, the crystal melting peak temperature of the copolymer is 100°C or higher, and the heat of crystal fusion thereof is from 5 to 70 J/g. Preferably, the crystal melting peak temperature is 105°C or higher, more preferably 110°C or higher; and the upper limit of the temperature is generally 145°C. Also preferably, the heat of crystal fusion of the copolymer is from 10 to 60 J/g, more preferably from 15 to 55 J/g. The method for measuring the crystal melting peak temperature and the heat of crystal fusion is as mentioned above.

In general, solar cell modules are heated up to 85 to 90°C or so by the heat generated during power generation or by the radiation heat of sunlight; however, so far as the crystal melting peak temperature thereof is 100°C or higher, the copolymer can favorably secure the heat resistance of the encapsulant material; and on the other hand, when the upper limit temperature is 145°C, then it is favorable since the encapsulant step for solar cell elements does not require so high temperatures. In addition, when the heat of crystal fusion falls within the above range, it is also favorable since the softness and the transparency (total light transmission) of the encapsulant material can be secured and the raw material pellets are free from a trouble of blocking.

### [Resin Composition (C)]

The resin composition (C) comprises the above-mentioned ethylene-α-olefin random copolymer (A) and the above-mentioned ethylene-α-olefin-block copolymer (B). In this, the α-olefin to be used in the copolymer (A) and the copolymer (B) may be the same or different; however, in the present invention, the α-olefin in the two is preferably the same since the miscibility of the two copolymers in mixing is good and the transparency of the resulting composition is high, or that is, the photoelectric conversion efficiency of solar cells using the composition is high.

Next, the content of the ethylene-α-olefin random copolymer (A) and the content of the ethylene-α-olefin block copolymer (B) in the resin composition (C) are, in consideration of the balance among the softness, the heat resistance and the transparency of composition, preferably from 50 to 99% by mass and from 1 to 50% by mass, respectively, more preferably from 60 to 98 parts by mass and from 2 to 40 parts by mass, respectively, even more preferably from 70 to 97 parts by mass and from 3 to 30 parts by mass, respectively. The blend (content) ratio by mass of the ethylene-α-olefin random copolymer (A) to the ethylene-α-olefin block copolymer (B) is not specifically defined, but is preferably (A)/(B) = (99 to 50) / (1 to 50), more preferably (98 to 60)/(2 to 40), even more preferably (97 to 70)/3 to 30), still more preferably (97 to 80)/(3 to 20), further more preferably (97 to 90)/(3 to 10). The total of (A) and (B) is 100 parts by mass. The blend (content) ratio by mass falling within the range is preferable as readily providing a solar cell encapsulant material well-balanced in softness, heat resistance and transparency.

Any other resin than the above-mentioned ethylene-α-olefin random copolymer (A) and the ethylene-α-olefin block copolymer (B) may be mixed in the resin composition (C), not overstepping the spirit and the scope of the present invention and for the purpose enhancing various physical properties (softness, heat resistance, transparency, adhesiveness, etc.) and also the moldability, the workability and the economic potential of the composition. The additional resin includes, for example, other polyorefin-based resins and various elastomers (olefinic, styrenic and others), resins modified with a polar group such as a carboxyl group, an amino group, an imide group, a hydroxyl group, an epoxy group, an oxazoline group, a thiol group, a silanol group or the like, tackiness-imparting resins, etc.

The tackiness-imparting resin includes petroleum resins, terpene reins, coumarone-indene resins, rosin-based resins, and their hydrogenated derivatives, etc. Concretely, as petroleum resins, there are mentioned alicyclic petroleum resins from cyclopentadiene or its dimer, and aromatic petroleum resins from a C9 component; as terpene resins, there are mentioned terpene resins and terpene-phenol resins from β-pinene; and as rosin-based resins, there are mentioned rosin resins such as gum rosin, wood rosin, etc., and esterified rosin resins modified with glycerin, pentaerythritol or the like. Mainly depending on the molecular weight thereof, the tackiness-imparting resin may have a different softening temperature. From the viewpoint of the miscibility thereof with the above-mentioned ethylene-α-olefin random copolymer (A) and ethylene-α-olefin block copolymer (B), and the time-dependent bleeding behavior thereof, and also the color and the thermal stability thereof, preferred are hydrogenated derivatives of alicyclic petroleum resins having a softening temperature of from 100 to 150°C, preferably from 120 to 140°C. In case where any other resin than the above-mentioned (A) and (B) is mixed in the resin composition, in general, its content is preferably 20% by mass or less relative to 100% by mass of the resin composition (C), more preferably 10% by mass or less.

If desired, various types of additives may be added to the resin composition (C). The additives include, for example, a silane coupling agent, an antioxidant, a UV absorbent, a weather-resistant stabilizer, a light diffusing agent, a nucleating agent, a pigment (e.g., white pigment), a flame retardant, a discoloration inhibitor, etc. In the present invention, preferred is adding at least one additive selected from a silane coupling agent, an antioxidant, a UV absorbent and a weather-resistant stabilizer for the reasons mentioned below. In the present invention, a crosslinking agent and a crosslinking promoter may be added to the resin composition (C); and for example, in case where high-level heat resistance is desired for the composition, a crosslinking agent and/or a crosslinking promoter may be added thereto.

The silane coupling agent is effective for enhancing the adhesiveness of the composition to a weather-resistant layer and a solar cell element; and as its examples, there are mentioned compounds having an unsaturated group such as a vinyl group, an acryloxy group or a methacryloxy group, as well as an amino group, an epoxy group or the like, and additionally having a hydrolysable group such as an alkoxy group. Specific examples of the silane coupling agent include N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane, etc. In the present invention, preferred is use of γ-glycidoxypropyltrimethoxysilane or γ-methacryloxypropyltrimethoxysilane as securing good adhesiveness and causing little discoloration such as yellowing. The amount of the silane coupling agent to be added is generally from 0.1 to 5 parts by mass or so relative to 100 parts by mass of the resin composition (C), preferably from 0.2 to 3 parts by mass. Like the silane coupling agent, any other coupling agent of an organic titanate compound or the like may also be used effectively here.

Various commercial products are usable here as the antioxidant. There are mentioned various types of antioxidants such as monophenol-type, bisphenol-type, polymeric phenol-type, sulfur-containing and phosphite-type antioxidants, etc. The monophenol-based antioxidants include, for example, 2,6-di-tert-butyl-p-cresol, butylated hydroxyanisole, 2,6-di-tert-butyl-4-ethylphenol, etc. The bisphenol-type antioxidants include 2,2'-methylenebis(4-methyl-6-tert-butylphenol), 2,2'-methylenebis(4-ethyl-6-tert-butylphenol), 4,4'-thiobis(3-methyl-6-tert-butylphenol), 4,4'-butylidenebis(3-methyl-6-tert-butylphenol), 3,9-bis[{1,1-dimethyl-2-{β-(3-tert-butyl-4-hydroxy-5-methylphenyl)propionyloxy}ethyl}2,4,9,10-tetroxaspiro]-5,5-undecane, etc.

The polymeric phenol-type antioxidants include 1,1,3-tris(2-methyl-4-hydroxy-5-tert-butylphenyl)butane, 1,3,5-trimethyl-2,4,6-tris(3,5-di-tert-butyl-4-hydrpxybenzyl)benzene, tetrakis-{methylene-3-(3',5'-di-tert-butyl-4'-hydroxyphenyl)propionate}methane, bis{(3,3'-bis-4'-hydroxy-3'-tert-butylphenyl)butyric acid} glucose ester, 1,3,5-tris(3',5'-di-tert-butyl-4'-hydroxybenzyl)-s-triazine-2,4,6-(1H,3H,5H)trione, triphenol (vitamin E), etc.
The sulfur-containing antioxidants include dilauroyl thiodipropionate, dimyristyl thiodipropionate, distearyl thiopropionate, etc.

The phosphite-type antioxidants include triphenyl phosphite, diphenylisodecyl phosphite, phenyldiisodecyl phosphite, 4,4'-butylidene-bis(3-methyl-6-tert-butylphenyl-di-tridecyl) phosphite, cyclic neopentane-tetrayl bis(octadecyl)phosphite, tris(mono and/or di)phenyl phosphite, diisodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-decyloxy-9,10-dihydro-9-oxa-10-phosphaphenanthrene, cyclic neopentane-tetrayl bis(2,4-di-tert-butylphenyl) phosphite, cyclic neopentane-tetrayl bis(2,6-di-tert-methylphenyl) phosphite, 2,2-methylenebis(4,6-tert-butylphenyl)octyl phosphite, etc.
In the present invention, preferably used are phenol-type and phosphite-type antioxidants from the viewpoint of the effect, the thermal stability and the economic potential thereof, and more preferably the two different types of antioxidants are combined for use herein. The amount of the antioxidant to be added is generally from 0.1 to 1 part by mass or so relative to 100 parts by mass of the resin composition (C), but preferably from 0.2 to 0.5 parts by mass.

As the UV absorbent, there are mentioned the same as those to be used in the above-mentioned weather-resistant layer. The amount of the UV absorbent to be added is generally from 0.01 to 2.0 parts by mass or so relative to 100 parts by mass of the resin composition (C), but preferably from 0.05 to 0.5 parts by mass.

As the weather-resistant stabilizer for imparting weather resistance apart from the above-mentioned UV absorbent, usable are the same as those to be used in the above-mentioned weather-resistant layer. Preferred are the hindered amine-type stabilizers. The hindered amine-type light stabilizer does not absorb UV rays, different from UV absorbents, but when combined with a UV-absorbent, it exhibits a noticeable synergistic effect. Some others than hindered amine-type compounds may function as a light stabilizer, but many of such compounds are colored and are therefore unfavorable for use in the encapsulant resin layer in the present invention.
As hindered amine-type light stabilizer, there are mentioned the same as those to be used in the above-mentioned weather-resistant layer. The amount of the hindered amine-type light stabilizer to be added is generally from 0.01 to 0.5 parts by mass or so relative to 100 parts by mass of the resin composition (C), but is preferably from 0.05 to 0.3 parts by mass.

### [Encapsulant Resin Layer]

Not specifically defined, the thickness of the encapsulant resin layer in the present invention is preferably within a range of from 50 to 1000 µm, and from the viewpoint of handleability, more preferably from 100 to 700 µm, even more preferably from 300 to 500 µm.

The encapsulant resin layer may be suitably controlled in point of the softness thereof, in consideration of the shape and the thickness of the solar cell to which it is applied and of the site where the solar cell is installed. For example, the storage elastic modulus (E') of the encapsulant resin layer is preferably from 1 to 2000 MPa, as measured through dynamic viscoelasticity measurement at an oscillation frequency of 10 Hz and at a temperature of 20°C. In consideration of the ability thereof to protect solar cell elements, the storage elastic modulus (E') of the encapsulant resin layer is preferably lower, but in consideration of the handleability of the encapsulant resin layer that is prepared in the form of a sheet or the like or in consideration of the other matter of the sheet-like encapsulant resin layer that the sheets are prevented from blocking together at their surfaces, the storage elastic modulus of the encapsulant resin layer is preferably from 3 to 1000 MPa, more preferably from 5 to 500 MPa, even more preferably from 10 to 100 MPa.

The heat resistance of the encapsulant resin layer is influenced by various properties of the ethylene-α-olefin random copolymer (A) (crystal melting peak temperature, heat of crystal fusion, MFR, molecular weight, etc.), and various properties of the ethylene-α-olefin block copolymer (B) (crystal melting peak temperature, heat of crystal fusion, MFR, molecular weight, etc.), and is especially strongly influenced by the crystal melting peak temperature of the ethylene-α-olefin block copolymer (B).
In general, solar cell modules are heated up to 85 to 90°C or so by the heat generated during power generation or by the radiation heat of sunlight; however, so far as the crystal melting peak temperature is 100°C or higher, the encapsulant resin layer can favorably secure the heat resistance thereof. In the cover film for solar cells of the present invention, the heat resistance and the elastic modulus of the encapsulant resin layer are the lowest in all the layers constituting the film, and accordingly, the heat resistance of the cover film for solar cells of the present invention depends on the performance of the encapsulant resin layer in the film.
In the present invention, a sheet-like sample having a thickness of 0.5 mm of the encapsulant resin layer is sandwiched between a white glass board having a thickness of 3 mm (size: 75 mm in length, 25 mm in width) and an aluminium plate having a thickness of 5 mm (size: 120 mm in length, 60 mm in width), and laminated under pressure using a vacuum pressing machine at 150°C for 15 minutes to produce a laminate sample; the sample is installed in a constant-temperature tank at 100°C, as inclined by 60 degrees therein; and after 500 hours, the condition of the laminate sample is checked. In the test, those in which the glass did not shift from the initial standard position are considered good (○), while whole in which the glass shifted from the initial standard position or in which the sheet melted are considered not good (x); and in that manner, the heat resistance of the encapsulant material was evaluated.

The total light transmission, as measured according to JIS K7105, of the encapsulant resin layer may not be that important depending on the type of the solar cells to which the encapsulant resin layer is applied, or for example, in a case where the encapsulant resin layer is applied to amorphous thin-film silicon parts or the like at which the sunlight to reach solar cell elements is not so much blocked; however, in consideration of the photoelectric conversion efficiency of solar cells to which the encapsulant resin layer is applied or of the handleability of the encapsulant resin layer in laminating various parts therewith, the total light transmission of the encapsulant resin layer is preferably 85% or higher, more preferably 87% or higher, even more preferably 90% or higher.

The softness, the heat resistance and the transparency of the encapsulant resin layer may be often paradoxical properties. Concretely, when the crystallinity of the resin composition (C) to be used is too much lowered for enhancing the softness thereof, then the heat resistance thereof may lower and may be therefore insufficient. On the other hand, when the crystallinity of the resin composition (C) to be used is too much increased for increasing the heat resistance thereof, then the transparency may lower and may be therefore insufficient. In consideration of the balance among these in the present invention, when the storage elastic modulus (E') in dynamic viscoelasticity measurement at an oscillation frequency of 10 Hz and at a temperature of 20°C is referred to as the index of softness, when the crystal melting peak temperature, as measured at a heating rate of 10°C/min in differential scanning calorimetry, is referred to as the index of heat resistance, and when the total light transmission is referred to as the index of transparency, it is desirable that these three indices are that the storage elastic modulus (E') is from 1 to 2000 MPa, the crystal melting peak temperature is 100°C or higher and the total light transmission is 85% or higher, for the purpose of satisfying all those softness, heat resistance and transparency; and more preferably, the storage elastic modulus (E') is from 5 to 500 MPa, the crystal melting peak temperature is from 105 to 145°C and the total light transmission is 85% or higher, even more preferably, the storage elastic modulus (E') is from 10 to 100 MPa, the crystal melting peak temperature is from 110 to 145°C and the total light transmission is 90% or higher.

### <Cover Film for Solar Cells>

The cover film for solar cells of the present invention can be produced by laminating the above-mentioned weather-resistant layer or a surface protective layer containing the weather-resistant layer, and the above-mentioned encapsulant resin layer.
The lamination method is not specifically defined. For example, individual layers of a weather-resistant layer or a surface protective layer containing a weather-resistant layer, and an encapsulant resin layer are separately prepared and then laminated according to a thermal lamination method, a dry lamination method or the like, or a weather-resistant layer or a surface protective layer is formed, and then an encapsulant resin layer is laminated on the weather-resistant layer or the surface protective layer according to an extrusion lamination method, an extrusion coating method, a calender-coating method or the like, or any of a weather-resistant layer or a surface protective layer is co-extruded and laminated with an encapsulant resin layer; and any of these modes may be selected here. In the present invention, from the viewpoint of easiness in thickness control and from the viewpoint of good appearance (transparency, etc.) and good productivity, a co-extrusion method and an extrusion lamination method are preferably employed.

As the film formation method in a case where the weather-resistant layer and the encapsulant resin layer are separately formed, or in a case of coextrusion where the polyolefin-based resin layer, the moisture-proof layer and the weather-resistant layer for the resin encapsulant layer or the surface protective layer are formed, herein employable is a known method, for example, an extrusion casting method, a calendering method or the like using a melt mixing apparatus equipped with a single-screw extruder, a multi-screw extruder, a Banbury mixer, a kneader or the like and using a T-die. Though not specifically defined, in the present invention, preferred is an extrusion casting method using a T-die, from the viewpoint of the handleability and the productivity.

The molding temperature in the extrusion casting method using a T-die may be suitably controlled depending on the flow properties and the film formability of the resin composition used, but may be generally from 130 to 300°C, preferably from 150 to 250°C. Various additives such as a silane coupling agent, an antioxidant, a UV absorbent, a weather-resistant stabilizer and the like may be previously dry-blended with resin and then fed into a hopper; or all the materials may be previously melt-mixed and pelletized, and then the pellets may be fed thereinto; or a master batch in which the additives alone are previously concentrated in resin may be prepared and fed into the production line.
Also employable here is a pressure lamination method where individual layers of a weather-resistant layer or a surface protective layer are film-like laminated with an encapsulant resin layer to which various additives have been added, through a feed block or a multi-manifold die or the like, then cooled on a chill roll and bonded under pressure, thereby giving a sheet having excellent interlayer adhesiveness.

If desired, the surface or the back of the weather-resistant layer, the surface protective layer or the encapsulant resin layer that has been formed in the form or a sheet may be embossed or may be processed in any other mode to form projections thereon (in conical, pyramid-like, hemisphere-like or any other form), for the purpose of preventing the surfaces of the sheet from blocking together in rolling up the sheet or for the purpose of enhancing the handleability and the degassing operation in a sealing process for solar cell elements.
Further, in producing sheets, any other substrate film (for example, oriented polyester film (OPET), oriented polypropylene film (OPP), etc.) may be laminated according to a method of extrusion lamination, sandwich lamination or the like. The layers of the above-mentioned weather-resistant layer, the surface protective layer and the encapsulant resin layer, and the layers constituting the surface protective layer may be surface-treated on at least one side thereof through corona treatment, plasma treatment or the like for enhancing the interlayer adhesiveness (peeling strength) between the layers.

In the above, the thermal lamination method, the dry lamination method, the extrusion lamination method, the extrusion coating method, the calender-coating method and the coextrusion method are all known lamination methods, and these are described briefly below.
The thermal lamination method is a method where two films of, for example, a weather-resistant layer and an encapsulant resin layer that have been previously formed are placed one upon another and thermally bonded under heat and pressure using hot rolls or the like.
The dry lamination method is a method where two films of, for example, a weather-resistant layer and an encapsulant resin layer that have been previously formed are used, and a two-component curable polyurethane-based adhesive or the like is applied onto one film, for example, on the surface of a weather-resistant layer on which the other film is to be laminated, then the solvent ingredient is removed through hot air drying, and while the coated film is still in a tacky (adhesive) state, the other film, or that is, an encapsulant resin layer is placed thereon and bonded under pressure, and thereafter the resulting laminate is wound up generally in a roll, and stored at room temperature or a relatively low heating temperature to thereby cure the adhesive with time to bond the two films.

The extrusion lamination method is a method where two films of, for example, a weather-resistant layer and an encapsulant resin layer that have been previously formed are film-like melt-extruded through a T-die with a heat-sensitive adhesive resin put therebetween, then bonded under pressure, and cooled for lamination.
The extrusion coating method is a method where a film of, for example, a weather-resistant layer is previously formed as a substrate, then optionally an anchor coat (a type of primer coat) is applied onto the surface thereof which is to be laminated with another film, and the above-mentioned resin composition (C) is melt-extruded as a film thereon through a T-die, and cooled with a chill roll and bonded under pressure for lamination.
The calender-coating method is a method where a thermoplastic resin, for example, the above-mentioned resin composition (C) in this case is heated and calender-molded in a film and simultaneously this is put on one surface of a weather-resistance layer, bonded under pressure and cooled for lamination. Also in this case, an anchor coat may be formed on the surface of the weather-resistant layer on which the resin layer is laminated.
The coextrusion method is a method where layers of, for example, a weather-resistant layer and an encapsulant resin layer are laminated as layers through a feed block or a multi-manifold die, then cooled with a chill roll and bonded under pressure for lamination. As the case may be, an adhesive layer may be arranged between the two layers.

According to the above-mentioned production methods, it is possible to continuously laminate a wide and long weather-resistant layer or a surface protective layer containing it and an encapsulant resin layer, and consequently, a cover film for solar cells of the present invention can be produced with good productivity.

The cover film for solar cells of the present invention is not specifically defined in point of the layer configuration thereof so far as at least one weather-resistant layer or surface protective layer and at least one encapsulant resin layer are laminated, but in general, the cover film is preferably so designed that the encapsulant resin layer exists as the innermost layer adhering to a solar cell element and the weather-resistant layer exists as the outermost layer opposite to the encapsulant resin layer. In the cover film for solar cells, the encapsulant resin layer and the surface protective layer are laminated in that order from the power generation element to be adjacent to the cover film.
For example, preferably mentioned are a two type/two layer (or more) configuration of weather-resistant layer or surface protective layer containing it/encapsulant resin layer; a three-type/three-layer (or more) configuration of weather-resistant layer or surface protective layer containing it/adhesive layer/encapsulant resin layer; a two-type/four layer (or more) configuration of weather-resistant layer or surface protective layer containing it/encapsulant resin layer/weather-resistant layer or surface protective layer containing it/encapsulant resin layer, etc. In the present invention, the configuration realizes preventing the moisture-proof layer from degrading and attaining long-term high-level moisture proofness and weather resistance.

In case where the cover film for solar cells of the present invention is a surface protective sheet, the reflectivity to the incident light running into the back of the encapsulant resin layer may not be that important depending on the type of the solar cells to which the cover film is applied, or for example, in a case where the cover case is applied to amorphous thin-film silicon parts or the like at which the sunlight to reach solar cell elements is not blocked; however, in consideration of the photoelectric conversion efficiency of solar cells to which the cover film is applied or of the handleability of the cover film in laminating various parts thereof, the reflectivity is preferably 80% or higher, and especially for attaining high power generation efficiency, the reflectivity is more preferably 82% or higher. The reflectivity may be measured according to JIS Z8722 as described below.

The softness of the cover film for solar cells of the present invention depends on the total thickness of the cover film or on the thickness constitutional ratio of the weather-resistant layer or the surface protective layer to the encapsulant resin layer. In general, since the encapsulant resin layer is relatively greatly thicker than the weather-resistant layer or the surface protective layer, the softness of the encapsulant resin layer may be referred to in evaluating the softness of the cover film of the present invention.
In case where the weather-resistant layer and the encapsulant resin layer are laminated, the total thickness of the cover film is, though not specifically defined, preferably within a range of from 55 to 1200 µm, more preferably within a range of from 110 to 800 µm.
The thickness ratio of weather-resistant layer/encapsulant resin layer is preferably within a range of from 1/200 to 1/5, more preferably from 1/100 to 1/10.
In case where the surface protective layer and the encapsulant resin layer are laminated, the cover film for solar cells of the present invention is used as a sheet having a thickness of, though not specifically defined, generally from 0.40 to 2.3 mm or so, preferably from 0.5 to 1.6 mm or so, more preferably from 0.60 to 1.0 mm or so. Also, the thickness ratio of the surface protective layer/the encapsulant resin layer is within a range of preferably from 1/50 to 1/5 and more preferably from 1/30 to 1/10.

Regarding the adhesiveness between the weather-resistant layer or the surface protective layer and the encapsulant resin layer in the cover film for solar cells of the present invention, the interlayer peeling strength therebetween, as measured according to JIS K6845, is preferably at least 10 N/cm width, more preferably at least 20 N/cm width.

The heat resistance of the cover film for solar cells of the present invention is evaluated as follows: Two samples of the cover film (length 75 mm, width 25 mm) are put one upon another in such a manner that the encapsulant resin layers of the two could overlap by a length of 25 mm, and a marked line is given to the overlapping part. Using a vacuum pressing machine, this is pressed and laminated at 150°C for 15 minutes to prepare a test sample. A 10-g weight is fitted to the lower edge of the sample, and kept in a constant-temperature tank at 100°C while hung in the vertical direction therein. After 500 hours, the condition of the sample is checked. Those in which the marked line given to the overlapping part did not shift are evaluated as good (○); and those in which the marked line given to the overlapping part shifted or the sheet peeled are evaluated as not good (x).

The total light transmission of the cover film for solar cells of the present invention, as measured according to JIS K7105, is, in general, preferably 85% or higher in consideration of the photoelectric conversion efficiency of solar cells, more preferably 87% or higher, even more preferably 90% or higher.

As described above, the cover film for solar cells of the present invention comprises the above-mentioned encapsulant resin layer excellent in softness, transparency and heat resistance, and the above-mentioned weather-resistant layer or the surface protective layer containing it, in which the two layers are laminated, and consequently, the cover film is excellent in handleability and realizes reduction in the weight of solar cell modules and enhances the impact resistance and the durability of solar cell modules. Specifically, from the above-mentioned thickness ratio of weather-resistant layer or surface protective layer/encapsulant resin layer, the encapsulant resin layer is, in general, relatively greatly thicker than the weather-resistant layer or the surface protective layer, and therefore the properties of the encapsulant resin layer have significant influences on the performance of the cover film obtained herein. Accordingly, since the encapsulant resin layer is excellent in softness, transparency and heat resistance, the cover film for solar cells obtained in the invention has excellent handleability and therefore secures excellent impact resistance and durability of solar cell modules using the cover film. Further, in the present invention, the weather-resistant layer or the surface protective layer constituting the cover film for solar cells is excellent in weather resistance, moisture proofness, transparency and heat resistance, and has high adhesiveness to the encapsulant resin layer adjacent thereto, and consequently, the above-mentioned advantages of the present invention can be thereby further augmented.
From the above, the above-mentioned cover film for solar cells of the present invention is favorably used as the front protective sheet and or the back protective sheet for solar cell modules.
In the present invention, the "front" and the "upper part" of solar cell module mean the sunlight-receiving side thereof; and the "back" and the "lower part" thereof mean the side opposite to the sunlight-receiving side.

### <Solar Cell Module>

Using the cover film for solar cells of the present invention (hereinafter referred to as the "cover film of the present invention"), a solar cell module of the present invention can be produced in which the upper part of the solar cell element is fixed with the cover film of the present invention and the lower part thereof is fixed with an encapsulant resin layer and a back protective sheet (back sheet) each serving as a protective material. The transparent substrate that serves as a protective material for the upper part of a solar cell element, or that is, the front protective sheet (front sheet) and the encapsulant material of the lower part may also be fixed with the cover film of the present invention. Further, both the upper part and the lower part may be formed by the use of the cover film of the present invention, thereby producing a solar cell module of the present invention. Various types of such solar cell modules can be exemplified.

One concrete example is shown in Fig. 1, in which cover films 10A and 10B for solar cells of the present invention (in this case, the encapsulant resin layer 10B is arranged on the solar cell element side), solar cell elements 12A and 12B, an encapsulant material 14 and a back sealing sheet 16 are laminated in that order from the sunlight-receiving side, and further, a junction box 18 (terminal box for connecting a wiring for taking out the generated electricity from the solar cell element) is adhered to the lower surface of the back sealing sheet 16. The solar cell elements 12A and 12B are connected by the wiring 20 for electrically leading the generated current to the outside. The wiring 20 is led to the outside via the through-hole (not shown) formed in the encapsulant material 14 and the back sealing sheet 16, and is connected to the junction box 18.

When water penetrates into the solar cell module, the module begins to degrade, and therefore, in case where an attachment such as the junction box is attached thereto, it is necessary to fully secure the sealing fixture in order that outdoor air could not penetrate into the solar cell module. In this connection, the cover film for solar cells of the present invention attain attachment merely by heating treatment, and can readily and surely prevent outdoor air from penetrating into the module.

In the solar cell module of the present invention, in case where an encapsulant material is used in at least two sites, the cover film of the present invention may be used in all those sites, and an encapsulant material comprising a different resin composition may also be used. In case where the encapsulant resin layer is used in the site that requires light permeability, the layer must be transparent, but when used as the back protective sheet, the encapsulant resin layer is not necessarily transparent.

The back sealing sheet to constitute the solar cell module produced by the use of the cover film for solar cells of the present invention may be a single-layer or multi-layer sheet including metals and various types of thermoplastic resin films, and for example, there are mentioned a single-layer or multi-layer sheet of an inorganic material such as tin, aluminium, stainless or the like metal or glass, or a polyester, an inorganic substance-deposited polyester, a fluoro resin, a polyolefin, etc.
The transparent substrate may be a single-layer or multi-layer sheet of glass, acrylic resin, polycarbonate, polyester, fluoro resin, etc. For plastics, an inorganic thin film may be formed thereon for the purpose of imparting gas barrier performance thereto like that for the moisture-proof layer constituting the cover film for solar cells, or for the purpose of enhancing the heat resistance, the weather resistance, the mechanical strength, the charging resistance, the dimensional stability and the like, a crosslinking agent, an antioxidant, a light stabilizer, a UV absorbent, an antistatic agent, reinforcing fibers, a flame retardant, an antiseptic agent and the like may be added thereto, or as the case may be, various sheets may be laminated thereon. The thickness of the transparent substrate may be suitably defined in consideration of the strength, the gas barrier performance and the durability thereof.

As the solar cell element includes, for example, there are mentioned single-crystal silicon-based, polycrystal silicon-based, amorphous silicon-based, various compound semiconductor-based, dye-sensitized type, organic thin film-type or the like solar cell elements.

The production method for the solar cell module using the cover film for solar cells of the present invention is not specifically defined. For example, the production method comprises a step of laminating a cover film of the invention, a solar cell element, an encapsulant material and a back sealing sheet in that order and aligning them, a step of bonding them under heat and pressure through vacuum suction, and a step of trimming away the protruding encapsulant resin to give the intended module having a predetermined dimension. In the cover film of the present invention, the weather-resistant layer or a surface protective layer containing it and the encapsulant resin layer are previously laminated, and consequently, using the cover film of the type simplifies and facilitates the lamination and aligning step and the trimming step in the above-mentioned process. The bonding under heat and pressure may be attained readily according to an ordinary method using a vacuum laminator, with which the laminated members are bonded under heat and pressure at a temperature of from 120 to 150°C for a degassing time of from 2 to 15 minutes, under a pressing pressure of from 0.5 to 1 atm. and for a pressing time of from 8 to 45 minutes.

Comprising the cover film of the present invention excellent in heat resistance, softness, transparency and weather resistance, the solar cell module of the present invention is favorably used in various applications irrespective of indoor use or outdoor use for small-size solar cells and large-size solar cells

In the present invention, the term "layer" may include "film" and "sheet"; and the terms "film" and "sheet" may include "layer".

### EXAMPLES

The present invention is described in more detail with reference to the following Examples, however, the present invention is not limited at all by these Examples. The sheets mentioned in the specification were analyzed for their data and evaluations, as mentioned below. In this, the sheet running direction from extruder is referred to as a machine direction, and the direction perpendicular to that direction is referred to as a transverse direction.

### [Measurement and Evaluation Method]

### (1) Crystal Melting Peak Temperature (Tm)

Using Perkin Elmer's differential scanning calorimeter, trade name "Pyrisl DSC" and according to JIS K7121, about 10 mg of a sample was heated from -40°C to 200°C at a heating rate of 10°C/min, kept at 200°C for 5 minutes, and then cooled down to -40°C at a cooling rate of 10°C/min, and again this was heated up to 200°C at a heating rate of 10°C/min, and on the thermogram thus drawn through the cycle, the crystal melting peak temperature (Tm) (°C) was read.

### (2) Heat of Crystal Fusion (ΔHm)

Using Perkin Elmer's differential scanning calorimeter, trade name "Pyris1 DSC" and according to JIS K7122, about 10 mg of a sample was heated from -40°C to 200°C at a heating rate of 10°C/min, kept at 200°C for 5 minutes, and then cooled down to -40°C at a cooling rate of 10°C/min, and again this was heated up to 200°C at a heating rate of 10°C/min, and on the thermogram thus drawn through the cycle, the heat of crystal fusion (ΔHm) (J/g) was read.

### (3) Softness of Encapsulant Resin Layer

Using IT Measurement's viscoelasticity meter, trade name "Viscoelasticity Spectrometer DVA-200", a sheet-like encapsulant resin layer sample having a thickness of 0.5 mm was analyzed in the lateral direction, at an oscillation frequency of 10 Hz, at a strain of 0.1%, at a heating rate of 3°C/min and at a chuck-to-chuck distance of 25 mm, in a range from -150°C to 150°C, and from the acquired data, the storage elastic modulus (E') (MPa) at 20°C of the sample was obtained.

### (4) Heat Resistance of encapsulant Resin Layer

A sheet-like encapsulant resin layer sample having a thickness of 0.5 mm was sandwiched between a white glass board having a thickness of 3 mm (size: 75 mm in length, 25 mm in width) and an aluminium plate having a thickness of 5 mm (size: 120 mm in length, 60 mm in width), and laminated under pressure using a vacuum pressing machine at 150°C for 15 minutes to produce a laminate sample; the sample was installed in a constant-temperature tank at 100°C, as inclined by 60 degrees therein; and after 500 hours, the condition of the laminate sample was checked and evaluated according to the following standards.
(○) Glass did not shift from the initial standard position.
(×) Glass shifted from the initial standard position or the sheet melted.

### (5) total light transmission (transparency of encapsulant resin layer)

A sheet-like encapsulant resin layer sample having a thickness of 0.5 mm was sandwiched between two white glass boards each having a thickness of 3 mm (size: 75 mm in length, 25 mm in width), and laminated under pressure using a vacuum pressing machine at 150°C for 15 minutes to produce a laminate sample, and its total light transmission was measured according to JIS K7105. In addition, the sample was evaluated according to the following standards. The results are all shown below.
(○○) The total light transmission was 90% or higher.
(○) The total light transmission was from 85% to less than 90%.
(×) The total light transmission was less than 85%, or the sample was obviously cloudy (immeasurable).

### (6) Light Reflectivity

The light reflectivity of the back protective layer alone mentioned below, and the light reflectivity of the encapsulant layer/back protective layer laminate in Examples and Comparative Examples were measured (according to JIS Z 8722 and using Japan Denshoku's Spectro Color Meter SQ2000 at 550 nm with C light source). The light reflectivity of the back protective layer alone was compared with the light reflectivity of the encapsulant layer/back protective layer laminate, and the reflectivity reduction ratio [(light reflectivity of back protective layer alone - light reflectivity of encapsulant layer/back protective layer laminate)/light reflectivity of back protective layer alone] was evaluated according to the following standards. The results are all shown below.
(○○) The reflectivity reduction ratio was less than 5.0%.
(○) The reflectivity reduction ratio was from 5.0% to less than 6.0%.
(×) The reflectivity reduction ratio was 6.0% or higher, or the sample was obviously cloudy (immeasurable).

### (7) Adhesiveness (peeling strength) of Cover Film of the Invention

Films of a weather-resistant layer and an encapsulant resin layer (length 75 mm, width 15 mm) were put one upon another, and a Teflon™ sheet (length 30 mm, width 25 mm, thickness 300 µm) was sandwiched between the two layers. Using a vacuum pressing machine, this was laminated at 150°C and for 15 minutes to prepare a laminate sample. According to JIS K6845, the sample was tested for the peeling strength thereof at a test speed of 50 mm/min.
(○) 10 N/cm width or higher.
(×) Less than 10 n/cm width.

### (8) Heat Resistance of Cover Film of the Invention

Two sheets of a cover film produced by laminating a weather-resistant layer and an encapsulant resin layer (length 75 mm, width 25 mm) were put one upon another in such a manner that the encapsulant resin layers of the two could overlap by a length of 25 mm, and a marked line was given to the overlapping part. Using a vacuum pressing machine, this was pressed and laminated at 150°C for 15 minutes to prepare a test sample. A 10-g weight was fitted to the lower edge of the sample, and kept in a constant-temperature tank at 100°C while hung in the vertical direction therein. After 500 hours, the condition of the sample was checked, and evaluated according to the following standards.
(○) The marked line given to the overlapping part did not shift.
(×) The marked line given to the overlapping part shifted or the sheet peeled.

### (9) total light transmission (transparency of cover film)

The cover film produced by laminating a weather-resistant layer and an encapsulant resin layer (length 75 mm, width 25 mm) was analyzed for the total light transmission thereof according to JIS K7105. The acquired data are shown below. With the data, the sample was evaluated according to the following standards, and the results are also shown below.
(○○) The total light transmission was 90% or higher.
(○) The total light transmission was from 85% to less than 90%.
(×) The total light transmission was less than 85%, or the sample was obviously cloudy (immeasurable).

### [Constitutive Layers]

The constitutive layers (films) used here are shown below.

### (Encapsulant Resin Layer 1)

A resin composition (C) prepared by mixing 95 parts by mass of an ethylene-octene random copolymer (Dow Chemical's trade name: Engage 8200, octene content: 10.1 mol% (31% by mass), MFR: 5, Tm: 65°C, ΔHm: 53 J/g) (hereinafter abbreviated as A-1 as the ethylene-α-olefin random copolymer (A), and 5 parts by mass of an ethylene-octene block copolymer (Dow Chemical's trade name: Infuse D9100.05, octene content: 12.8 mol% (37% by mass), MFR: 1, Tm: 119°C, ΔHm: 38 J/g) (hereinafter abbreviated as B-1) as the ethylene-α-olefin block copolymer (B) was melt-kneaded at a preset temperature of from 200°C using a 40-mmφ single-screw extruder equipped with a T-die, and sheeted on a cast roll at 20°C in a mode of rapid cooling thereon, thereby giving a sheet-like encapsulant resin layer 1 having a thickness of 0.5 mm (500 µm) (hereinafter this is simply abbreviated as sheet). The sheet was evaluated, and the results are shown in Table 1.

### (Encapsulant Resin Layer 2)

A sheet having a thickness of 0.5 mm (500 µm) was obtained in the same manner as that for the encapsulant resin layer 1, except that the resin composition (C) was changed as in Table 1, or that is, the resin composition was changed to one comprising 80 parts by mass of (A-1), and 20 parts by mass of an ethylene-octene block copolymer (Dow Chemical's trade name: Infuse D9507.15, octene content: 16.4 mol% (44% by mass), MFR: 5, Tm: 123°C, ΔHm: 21 J/g) (hereinafter abbreviated as B-2). The sheet was evaluated, and the results are shown in Table 1.

### (Encapsulant Resin Layer 3)

A sheet having a thickness of 0.5 mm (500 µm) was obtained in the same manner that for the encapsulant resin layer 1, except that the resin composition (C) was changed as in Table 1, or that is, (A-1) therein was changed to an ethylene-propylene-hexene ternary random copolymer (Japan Polyethylene's trade name: Karner KJ640T, propylene content: 7.4 mol% (10% by mass), hexene content: 4.4 mol% (10% by mass), MFR: 30, Tm: 53°C, ΔHm: 58 J/g) (hereinafter abbreviated as A-2). The sheet was evaluated, and the results are shown in Table 1.

### (Encapsulant Resin Layer 4)

A sheet having a thickness of 0.5 mm (500 µm) was obtained in the same manner that for the encapsulant resin layer 1, except that the resin composition (C) was changed to 100 parts by mass of (A-1) alone as in Table 1. The sheet was evaluated, and the results are shown in Table 1.

### (Encapsulant Resin Layer 5)

A sheet having a thickness of 0.5 mm (500 µm) was obtained in the same manner that for the encapsulant resin layer 1, except that the resin composition (C) was changed as in Table 1, or that is, (B-1) therein was changed to an ordinary crystalline polyethylene resin, ethylene-octene random copolymer (Prime Polymer's trade name: Moretec 0238CN, octene content: 1 mol% (4% by mass), MFR: 2.1, Tm: 121°C, ΔHm: 127 J/g) (hereinafter abbreviated as P-1). The sheet was evaluated, and the results are shown in Table 1.

### (Encapsulant Resin Layer 6)

A sheet having a thickness of 0.5 mm (500 µm) was obtained in the same manner that for the encapsulant resin layer 1, except that the resin composition (C) was changed to 100 parts by mass of (P-1) alone as in Table 1. The sheet was evaluated, and the results are shown in Table 1.

### (Encapsulant Resin Layer 7)

An encapsulant resin layer 7 was obtained in the same manner that for the encapsulant resin layer 1, except that the thickness of the sheet was changed to 0.3 mm (300 µm). The sheet was evaluated, and the results are shown in Table 1.

### (Encapsulant Resin Layer 8)

Toyo Ink's urethane (PU)-based adhesive IS801 and curing agent CR001 were blended in a ratio of 10:1, and applied onto a silicone-lubricated PET film in a solid coating amount of 10 g/m², and cured at 40°C for 4 days. Subsequently, only the adhesive layer was taken out, and evaluated. The results are shown in Table 1.

### (Encapsulant Resin Layer 9 (reference))

For reference, Etimex's EVA sealant 496 was evaluated in the same manner as above. Briefly, the EVA sealant alone was laminated in vacuum according to the method shown in Examples given below, and subsequently, the EVA sealant alone was taken out and evaluated, and the results are shown in Table 1.

### (Polyolefin-based Resin Layer 1)

To an isotactic polypropylene resin, added were titanium oxide (8% by mass) as a whitening agent and ultrafine titanium oxide particles (particle size, 0.01 t 0.06 µm, 3% by mass) as a UV absorbent, and in addition, necessary additives were added thereto and fully kneaded to prepare a polypropylene resin composition. Next, the polypropylene resin composition was extruded out through an extruder to produce an unstretched polypropylene resin film having a thickness of 90 µm, and further one surface of the unstretched polypropylene resin film was processed for corona discharge treatment according to an ordinary method to form a corona-treated surface. The light reflectivity of the obtained resin film was 86.8%.

### (Moisture-proof Layer 1)

Used was Mitsubishi Plastics's TECHBARRIER LX produced by vapor-depositing silica in a thickness of 50 nm on a 12-µm polyethylene terephthalate resin film. Its moisture proofness as measured according to the above-mentioned method was 0.2 [g/ (m²·day)].

### (Weather-Resistant Layer 1)

Used was Alchema's polyvinylidene fluoride (PVDF) film, Kynar 302-PGM-TR (thickness: 30 µm).

### (Back Protective Layer 1)

Mitsui Chemical Polyurethane's A1102, and Mitsui Chemical Polyurethane's A3070 as a curing agent containing an aliphatic hexamethylene diisocyanate component were used. These were mixed in a ratio by weight of 16:1, and diluted with ethyl acetate to have a solid concentration of 30%, thereby preparing an adhesive coating liquid.

Subsequently, the adhesive coating liquid was applied onto the silica surface of the moisture-proof layer 1 in a coating solid of 6 g/m², then dried and dry-laminated to the weather-resistant layer 1.

Further, the adhesive coating liquid was applied to the corona-treated surface of the polyolefin-based resin layer 1 in a coating solid of 6 g/m², then dried and dry-laminated to the moisture-proof layer 1 of the previously-prepared laminate film. Afterwards, this was cured at 40°C for 5 days to produce a back protective layer 1 having a thickness of 144 µm.

The reflectivity of the surface of the polyolefin-based resin layer 1 was measured according to the above-mentioned method, and was 86.8% at 550 nm.

[Table 1]

**Table 1**

| | Thickness ((m) | Composition | total light transmission (%) | Heat Resistance | Softness (E') [MPa] |
|---|---|---|---|---|---|
| Encapsulant Resin Layer 1 | 500 | Engage 8200 +INFUSE D9100 | 90.4 (○○) | ○ | 12 |
| Encapsulant Resin Layer 2 | 500 | Engage 8200 + INFUSE D9507 | 87.1 (○) | ○ | 16 |
| Encapsulant Resin Layer 3 | 500 | Karnel KJ640T + INFUSE D9100 | 88.5 (○) | ○ | 27 |
| Encapsulant Resin Layer 4 | 500 | Engage 8200 | 92.0 (○○) | × | 12 |
| Encapsulant Resin Layer 5 | 500 | Engage 8200 + Moretec | 83.9 (×) | ○ | 38 |
| Encapsulant Resin Layer 6 | 500 | Moretec | cloudy (×) | ○ | 2640 |
| Encapsulant Resin Layer 7 | 300 | Engage 8200 + INFUSE D9100 | 90.4 (○○) | ○ | 12 |
| Encapsulant Resin Layer 8 | 10 | PU Adhesive Toyo Ink IS801 | 90.0 (○○) | × | 20 |
| Encapsulant Resin Layer 9 (reference) | 500 | Etimex's EVA 496 | 89.0 (○) | ○ | 200 |

### Example 1

A mixture prepared by mixing 100 parts by mass of the resin composition (C) for the encapsulant resin layer 1 and 0.5 parts by mass of γ-methacryloxypropyltrimethoxysilane (Shin-etsu Chemical's trade name: KBM-503) as a silane coupling agent was melt-kneaded with a 40-mmφ single-screw extruder equipped with a T-die at a preset temperature of 200°C, and bonded under pressure to an ETFE film (Asahi Glass's trade name: Aflex ETFE, having a thickness of 25 µm, and a water vapor permeability of 7 g/cm²·day through a thickness of 100 µm) that had been previously corona-treated, using rubber rolls, and then rapidly cooled with a cast roll at 20°C for film formation to give a sheet-like cover film for solar cells having a thickness of 0.525 mm according to an extrusion lamination method. The cover film was evaluated and the results are shown in Table 2.

### Example 2

A cover film for solar cells was produced according to an extrusion lamination method in the same manner as in Example 1 except that the resin composition (C) in Example 1 was changed to that used in preparing the encapsulant resin layer 2. The cover film was evaluated and the results are shown in Table 2.

### Example 3

A cover film for solar cells was produced according to an extrusion lamination method in the same manner as in Example 1 except that the resin composition (C) in Example 1 was changed to that used in preparing the encapsulant resin layer 3. The cover film was evaluated and the results are shown in Table 2.

### Example 4

A modified ETFE resin (adhesive ETFE resin) (Daikin's trade name: Neoflon EFEP RP-4020) as a weather-resistant layer, and, as an encapsulant resin layer, a mixture prepared by mixing 100 parts by mass of the resin composition (C) used in preparing the encapsulant resin layer 1 and 0.5 parts by mass of 2-(3,4-epoxycyclohexyl)ethyltrimethoxysilane (Shin-etsu Chemical's trade name: KBM-303) as a silane coupling agent were coextruded and laminated using a feed block and a T-die at a nozzle temperature of 200°C, in such a manner that the thickness of the weather-resistant layer could be 0.025 mm and the thickness of the encapsulant resin layer could be 0.5 mm, thereby producing a cover film for solar cells according to a coextrusion method. The cover film was evaluated and the results are shown in Table 2.

### Comparative Example 1

A cover film for solar cells was produced according to an extrusion lamination method in the same manner as in Example 1 except that the resin composition (C) in Example 1 was changed to that used in preparing the encapsulant resin layer 4. The cover film was evaluated and the results are shown in Table 2.

### Comparative Example 2

A cover film for solar cells was produced according to an extrusion lamination method in the same manner as in Example 1 except that the resin composition (C) in Example 1 was changed to that used in preparing the encapsulant resin layer 5. The cover film was evaluated and the results are shown in Table 2.

### Comparative Example 3

A cover film for solar cells was produced according to an extrusion lamination method in the same manner as in Example 1 except that the resin composition (C) in Example 1 was changed to that used in preparing the encapsulant resin layer 6. The cover film was evaluated and the results are shown in Table 2.

**[Table 2]**

| | Example | | | | Comparative Example | | |
|---|---|---|---|---|---|---|---|
| | 1 | 2 | 3 | 4 | 1 | 2 | 3 |
| Encapsulant Resin layer | 1 | 2 | 3 | 1 | 4 | 5 | 6 |
| Weather-Resistant Layer Lamination Method | extrusion lamination | | | coextrusion | extrusion lamination | | |
| Adhesiveness | ○ | ○ | ○ | ○ | ○ | ○ | ○ |
| Heat Resistance | ○ | ○ | ○ | ○ | × | ○ | ○ |
| total light transmission | 90.1 | 86.8 | 88.0 | 90.5 | 91.0 | 83.2 | (cloudy) |
| (%) | (○○) | (○) | (○) | (○○) | (○○) | × | × |

From Tables 1 and 2, it is confirmed that the cover films for solar cells of the present invention, as produced by laminating a weather-resistant layer and the encapsulant resin layer 1 to 3, are excellent in softness, heat resistance and transparency (total light transmission) and have good adhesiveness (Examples 1 to 4). As opposed to these, it is confirmed that the encapsulant resin layers not containing the block copolymer (B) for use in the present invention (encapsulant resin layers 4 to 6) are insufficient in at least any one properties of softness, heat resistance and transparency (total light transmission) (Comparative Examples 1 to 3). Concretely, it is confirmed that the heat resistance was insufficient (Comparative Example 1), or when increasing the heat resistance in Comparative Example 1 was tried by the use of an ordinary crystalline polyethylene resin, the heat resistance could be bettered but the transparency (total light transmission) was poor (Comparative Example 2).

### Example 5

The encapsulant resin layer 1 and the back protective layer 1 were laminated in that order using NPC's vacuum laminator LM-30×30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Example 6

The encapsulant resin layer 2 and the back protective layer 1 were laminated in that order using NPC's vacuum laminator LM-30×30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Example 7

The encapsulant resin layer 3 and the back protective layer 1 were laminated in that order using NPC's vacuum laminator LM-30x30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Example 8

The encapsulant resin layer 7 and the back protective layer 1 were laminated in that order using NPC's vacuum laminator LM-30x30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Comparative Example 4

The encapsulant resin layer 4 and the back protective layer 1 were laminated in that order using NPC's vacuum laminator LM-30x30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Comparative Example 5

The encapsulant resin layer 5 and the back protective layer 1 were laminated in that order using NPC's vacuum laminator LM-30x30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Comparative Example 6

The encapsulant resin layer 6 and the back protective layer 1 were laminated in that order using NPC's vacuum laminator LM-30x30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Comparative Example 7

The encapsulant resin layer 8 and the back protective layer 1 were laminated in that order using NPC's vacuum laminator LM-30×30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

### Reference Example 1

The encapsulant resin layer 9 (reference) and the back protective layer 1 were laminated in that order using NPC's vacuum laminator LM-30×30 and according to an ordinary method at 150°C and for 15 minutes, thereby producing an encapsulant layer/back protective layer laminate. Subsequently, the reflectivity of the produced encapsulant layer/back protective layer laminate product was measured according to the above-mentioned method. The result is shown in Table 3.

**[Table 3]**

| | Layer Configuration | Reflectivity at 550 nm[%] | I Reflectivity Reduction Ratio [%] | Evacuation of Reflectivity Reduction Ratio |
|---|---|---|---|---|
| Example 5 | Encapsulant resin layer 1/back protective layer 1 | 83.0 | 4.4 | ○○ |
| Example 6 | Encapsulant resin layer 2/back protective layer 1 | 82.1 | 5.4 | ○ |
| Example 7 | Encapsulant resin layer 3/back protective layer 1 | 82.3 | 5.2 | ○ |
| Example 8 | Encapsulant resin layer 7/back protective layer 1 | 82.6 | 4.8 | ○○ |
| Comparative Example 4 | Encapsulant resin layer 4/back protective layer 1 | 82.8 | 4.6 | ○○ |
| Comparative Example 5 | Encapsulant resin layer 5/back protective layer 1 | 81.5 | 6.1 | × |
| Comparative Example 6 | Encapsulant resin layer 6/back protective layer 1 | cloudy | - | × |
| Comparative Example 7 | Encapsulant resin layer 8/back protective layer 1 | 82.5 | 5.0 | ○ |
| Reference Example 1 | Encapsulant resin layer 9/back protective layer 1 | 82.4 | 5.1 | ○ |

The encapsulant layer/back protective layer laminates of Examples 5 to 8 thus produced as above all satisfied softness and heat resistance and were all excellent in reflectivity.
In addition, the encapsulant layer/back protective layer laminates of Examples 5 to 8 had a sufficient thickness and were well balanced in point of softness, heat resistance and reflectivity necessary for protecting moisture-proof layer, as shown in Table 3. Accordingly, the encapsulant layer/back protective layer laminates of Examples 5 to 8 not only satisfy both softness and heat resistance and are excellent in reflectance but also have obtained high reflectivity, and therefore can realize solar cell modules that are resistant to long-term use at high temperatures and under inclined conditions and secure high power generation efficiency.
Reference Example 1 is one typical case of EVA that has heretofore been used as an encapsulant material, and it is obvious that the encapsulant layer/back protective layer laminates of Examples 5 to 8 of the present invention all have a reflectivity on the same level as or on a higher level than that in Reference Example 1.

On the other hand, the encapsulant layer/back protective layer laminates of Comparative Examples 4 to 7 were insufficient in at least any one of softness, heat resistance and reflectivity. Concretely, the encapsulant resin layers 4 and 8 are poor in heat resistance, and it has become obvious that, when these are used at high temperatures and under inclined conditions, they shift from standard values or the sheets melt. Accordingly, in the encapsulant layer/back protective layer laminates produced by the use of the encapsulant resin layers 4 and 8, the encapsulant resin layer could not fulfill the role thereof and, as a result, in actually driving solar cell elements with the laminate therein at high temperatures, the moisture proofness and the reflectivity would be lowered. In other words, these laminates are unfavorable as materials for members of solar cells that are expected to be used at high temperatures and under inclined conditions (Comparative Example 4, Comparative Example 7). The encapsulant resin layer 6 was poor in softness (storage elastic modulus) and it was shown that the layer is insufficient for protecting modules against shock, etc. Accordingly, in the encapsulant layer/back protective layer laminate produced by the use of the encapsulant resin layer 6, the encapsulant resin layer could not fulfill the role thereof, and could not sufficiently protect moisture-proof layer (Comparative Example 6).

**DESCRIPTION OF REFERENCE NUMERALS AND SIGNS**

| | |
|---|---|
| 10A | Weather-Resistant Layer of Cover Film |
| 10B | Encapsulant Resin Layer of Cover Film |
| 12A, 12B | Solar Cell Element |
| 14 | Encapsulant Material |
| 16 | Back Sealing Sheet |
| 18 | Junction Box |
| 20 | Wiring |

## Claims

1. A cover film for solar cells, which has a weather-resistant layer, and an encapsulant resin layer comprising a resin composition (C) that contains an ethylene-α-olefin random copolymer (A) satisfying the following requirement (a) and an ethylene-α-olefin block copolymer (B) satisfying the following requirement (b):
(a) The heat of crystal fusion of the copolymer, as measured at a heating rate of 10°C/min in differential scanning calorimetry, is from 0 to 70 J/g;
(b) As measured at a heating rate of 10°C/min in differential scanning calorimetry, the crystal melting peak temperature of the copolymer is 100°C or higher, and the heat of crystal fusion thereof is from 5 to 70 J/g.

2. The cover film for solar cells according to claim 1, wherein the weather-resistant layer is one comprising, as the main component thereof, a resin composition containing at least one resin selected from acrylic resin, polycarbonate resin, polyethylene terephthalate resin and polyethylene naphthalate resin and a UV absorbent, or a fluoro resin.

3. The cover film for solar cells according to claim 2, wherein the fluoro resin is at least one resin selected from polytetrafluoroethylene, 4-fluoroethylene-perchloroalkoxy copolymers, 4-fluoroethylene-6-fluoropropylene copolymer, 2-ethylene-4-fluoroethylene copolymer, polychloro-trifluoroethylene, polyvinylidene fluoride, and polyvinyl fluoride.

4. The cover film for solar cells according to any one of claims 1 to 3, which further has a moisture-proof layer.

5. The cover film for solar cells according to claim 4, wherein the moisture-proof layer is one having at least one layer of a coating film of an inorganic oxide on at least one face of a substrate film.

6. The cover film for solar cells according to any one of claims 1 to 5, wherein the ethylene-α-olefin block copolymer (B) is an ethylene-octene multi-block copolymer.

7. The cover film for solar cells according to any one of claims 1 to 6, wherein the α-olefin that constitutes each of the ethylene-α-olefin random copolymer (A) and the ethylene-α-olefin block copolymer (B) is the same.

8. The cover film for solar cells according to any one of claims 1 to 7, wherein the weather-resistant layer and the encapsulant resin layer are laminated according to a coextrusion method or an extrusion lamination method.

9. The cover film for solar cells according to any one of claims 1 to 8, which is used as a front protective film.

10. The cover film for solar cells according to any one of claims 1 to 9, which is used as a back protective sheet.

11. The cover film for solar cells according to any one of claims 1 to 10, which further has a polyolefin-based resin layer.

12. The cover film for solar cells according to claim 11, wherein the polyolefin-based resin layer is a resin layer having a light reflectivity of 80% or higher.

13. A solar cell module produced by the use of the cover film for solar cells in any one of claims 1 to 12.
